# EUROPEAN PATENT SPECIFICATION

(11) **EP 2 804 320 B1**
(45) Date of publication and mention of the grant of the patent: **07.11.2018**
(21) Application number: 14165778.3
(22) Date of filing: 24.04.2014
(51) Int. Cl.: H03K 17/96, G06F 3/044, G06F 1/32, H04W 52/02

(54) **Button with capacitive touch in a metal body of a user device and power-saving touch key control of information to display**
Knopf mit kapazitivem Berührungselement in einem metallischen Körper einer Benutzervorrichtung und stromsparender Tastschaltersteuerung von anzuzeigenden Informationen
Bouton tactile capacitif dans un corps métallique d'un dispositif utilisateur et contrôle de touche tactile à économie d'énergie pour l'affichage d'informations

(30) Priority: 14.05.2013 US 201313893840
(43) Date of publication of application: 19.11.2014
(73) Proprietor: Sony Corporation, Tokyo 108-0075 (JP)
(72) Inventor: Rodzevski, Alexandar, 211 13 Malmö (SE); Klinghult, Gunnar, 223 59 Lund (SE); Begic, Stjepan, 218 37 Bunkeflostrand (SE)
(74) Representative: Kraus & Weisert Patentanwälte PartGmbB

(56) References cited:
- EP-A1- 0 678 987
- EP-A1- 2 434 645
- WO-A1-2011/018439
- GB-A- 2 319 878
- US-A1- 2007 024 564
- US-A1- 2007 119 698
- US-A1- 2008 257 707
- US-A1- 2009 008 234
- US-A1- 2010 035 656
- US-A1- 2010 171 753
- US-A1- 2011 043 227
- US-A1- 2012 154 182
- US-A1- 2012 199 459

## Description

### BACKGROUND

A button for both normal press and touch has been suggested. For example, when a user presses the button a haptic feedback is provided from an underlying dome switch. Additionally, when the user touches the button, the touch causes an event to occur. The button may use capacitive sensing to sense a user's touch. An example of a user device comprising a display, a capacitive touch button, a memory and a processor, wherein the processor is configured to display quick-look information in response to a user input where a user touches the capacitive touch button is disclosed for example in document US 2010/0171753 A1.

### SUMMARY

A user device and a corresponding method are defined in the appended claims.

### DESCRIPTION OF THE DRAWINGS

Fig. 1A is a diagram illustrating a cross sectional view of an exemplary embodiment of a conductive button having a flexible electrode structure;
Fig. 1B is a diagram illustrating an isometric view of the conductive button;
Fig. 1C is a diagram illustrating another isometric of the conductive button;
Fig. 1D is a diagram illustrating a cross sectional view of another exemplary embodiment of a conductive button having a flexible electrode structure;
Figs. 2A and 2B are diagrams illustrating exemplary outer components of an exemplary embodiment of a user device;
Fig. 3 is a diagram illustrating exemplary internal components of the user device;
Figs. 4A - 4C are diagrams illustrating exemplary functional components that provide quick-look information;
Fig. 5 is a diagram illustrating an exemplary pre-defined image on the user device; and
Fig. 6 is a flow diagram illustrating an exemplary process for providing quick-look information based on an activation of a touch button.

### DETAILED DESCRIPTION OF PREFERRED EMBODIMENTS

The following detailed description refers to the accompanying drawings. The same reference numbers in different drawings may identify the same or similar elements.

The location of use of a capacitive touch-sensitive button is limited due to the conductive materials, which are used by manufacturers, to encase or support the capacitive touch-sensitive button. For example, mobile devices, such as smartphones, tablets, netbooks, mobile phones, etc., or other types of devices, may include an outer shell or body made of metal or other conductive material. Thus, the conductive encasing of the device would not provide a suitable support structure for the capacitive touch-sensitive button since the metal body effectively diminishes any capacitance introduced by the user's touch.

According to an exemplary embodiment, a button with a capacitive touch includes a flexible electrode structure that connects the button to a touch sensing circuit. According to an exemplary embodiment, the flexible electrode structure includes a sensing layer, a screening layer, and an insulating layer. According to another exemplary embodiment, the flexible electrode structure includes a sensing layer and an insulating layer. According to an exemplary embodiment, the button is supported within a metal body of a device. According to an exemplary embodiment, an insulation layer surrounds a key portion of the button to prevent capacitance from dissipating into the metal body (or other conductive material) of the device.

According to an exemplary embodiment, the button provides a capacitive switching function (e.g., when a user touches a key portion of the button) and a pressure switching function (e.g., when a user presses the key down). According to an exemplary implementation, the screening layer, the insulating layer, and the sensing layer are made from a conductive rubber, which provides flexibility and allows for the pressure switching function. According to an exemplary implementation, the button may be used as a power button or a camera button (e.g., to enter a camera mode, perform a function of a camera (e.g., auto focus, zoom, etc.). According to other implementations, the button may be applied to other functions.

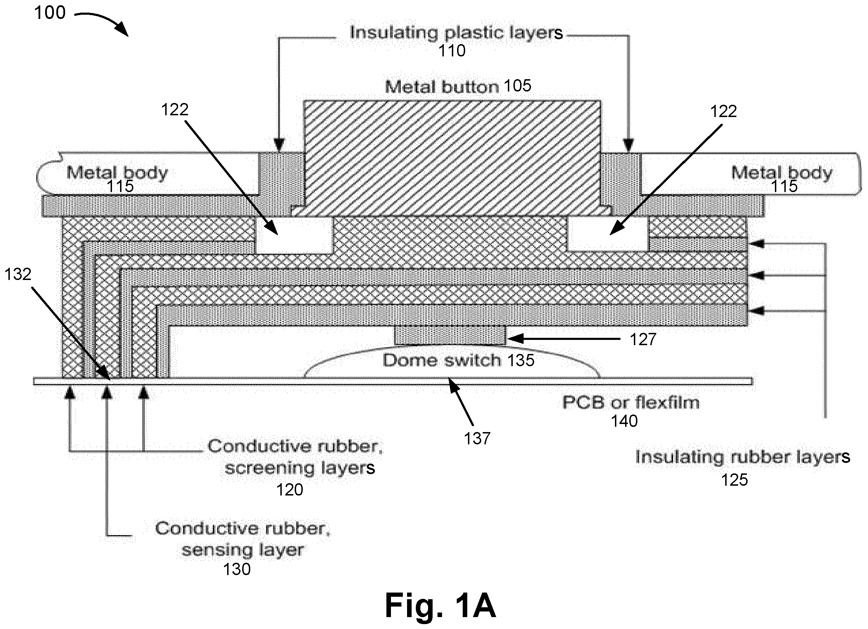

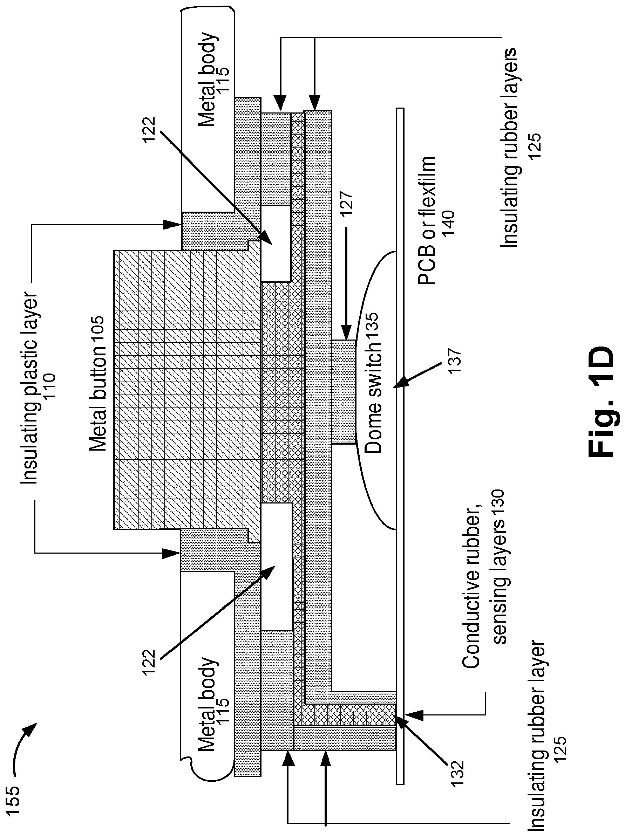

Fig. 1A is a diagram illustrating an exemplary embodiment of a conductive button 100 with a capacitive touch that includes a flexible electrode structure that connects the button to a touch sensing circuit. As illustrated, conductive button 100 includes a button 105 (also referred to as a key). For example, button 105 may be made of metal (e.g., aluminum, stainless, steel, etc.). Button 105 may be coated. For example, button 105 may be coated with a lacquer or a conductive plastic. By way of further example, the conductive plastic includes a conductive layer (e.g., a metal, such as chrome, etc.). Alternatively, button 105 maybe anodized.

As further illustrated, an insulating plastic layer 110 separates button 105 from a metal body 115. According to an exemplary implementation, insulating plastic layer 110 may be made from a polyamide-type plastic or a polycarbonate. Metal body 115 is part of a user device (not illustrated). Insulating plastic layer 110 prevents capacitance from leaking into metal body 115 when a user touches metal button 105. Additionally, insulating plastic layer 110 insulates or provides a barrier between metal body 115 and conductive rubber, screening layers 120. As illustrated, conductive button 100 includes air gaps 122.

Conductive button 100 also includes insulating rubber layers 125, an insulating rubber part 127, and a conductive rubber, sensing layer 130. According to an exemplary implementation, conductive rubber, screening layers 120 and conductive rubber, sensing layer 130 may be made from a silicone rubber that includes carbon or metal-plated particles or other flexible, conductive material. According to an exemplary implementation, insulating rubber layers 125 may be made from silicone rubber or other flexible, non-conductive material.

Insulating rubber layers 125 are arranged in a manner that provides an insulative pathway for conductive rubber, sensing layer 130 to a printed circuit board (PCB) or a flex film 140. Insulating rubber part 127 is in contact with the top of dome switch 135. Although not illustrated, PCB/flex film 140 includes a capacitive sensor surface 132. When a user touches metal button 105, the capacitance propagates via conductive, rubber sensing layer 130 to capacitive sensor surface 132. A detection unit (not illustrated) may detect a change in the capacitance or a change in the potential across capacitive sensor surface 132.

Conductive rubber, screening layers 120 surround insulating rubber layers 125. Conductive rubber, screening layers 120 protect conductive rubber, sensing layer 130 from stray capacitance and help yield an acceptable signal-to-noise ratio. That is, when a user touches the button, this will create a change of the current in the system (i.e., a signal).

A dome switch 135 is electrical coupled to PCB/flex film 140. The rubber layers (i.e., conductive rubber, screening layers 120, insulating rubber layers 125, and conductive rubber, sensing layer 130) offer a flexibility to allow enough movement of metal button 105 when metal button 105 is depressed to cause dome switch 135 to contact a pad 137 of PCB/flex film 140. A detection unit (not illustrated) may detect an actuation (e.g., pressing) of metal button 105 and dome switch 135 toward PCB/flexfilm 140.

As illustrated in Fig. 1A, the layers of conductive button 100 have an asymmetry. For example, on the left side of conductive button 100, conductive rubber, sensing layers 120, insulating rubber layers 125 and conductive rubber, sensing layer 130 extends to PCB/flexfilm 140. However, on the right side of conductive button 100, these layers do not extend to PCB/flexfilm 140.

According to an exemplary embodiment, conductive rubber, screening layers 120, insulating rubber layers 125, and conductive rubber, sensing layer 130 are molded together to form a gasket-like flexible structure. The rubber layers may be molded together using well-known techniques.

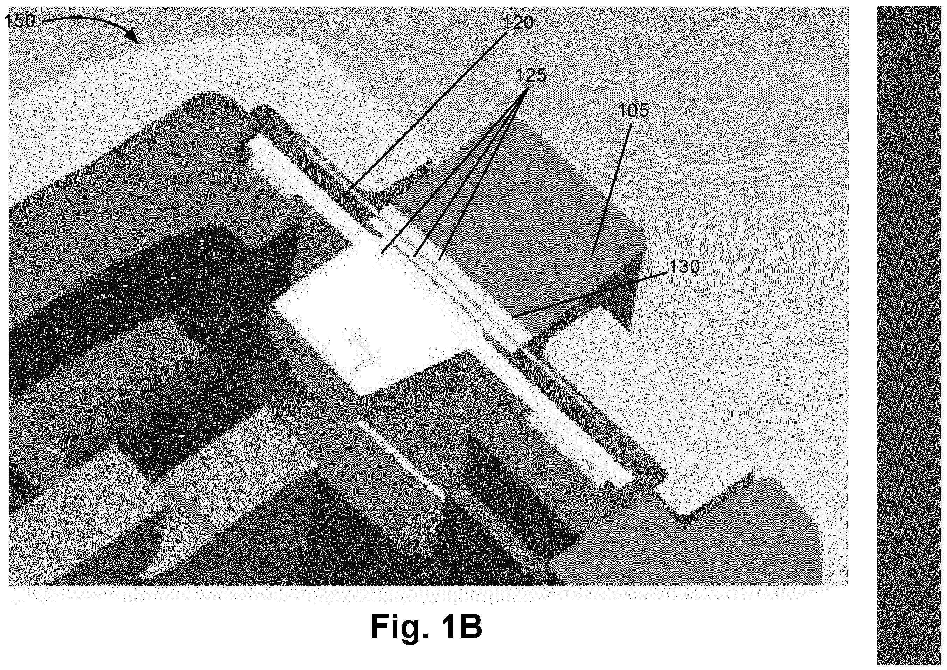

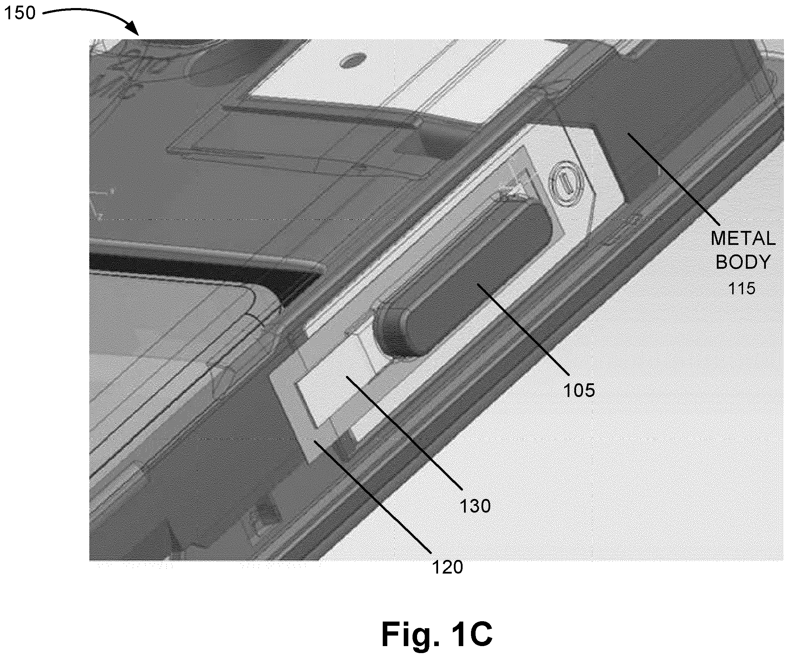

Figs. 1B and 1C illustrate various isometric views of conductive button 100 incorporated into a user device 150. User device 150 includes a metal body. For example, user device 150 may be implemented as a mobile device (e.g., a smartphone, a wireless telephone, a tablet device, a computer, etc.). According to other implementations, user device 150 may be implemented as various other types of devices.

Fig. ID is a diagram illustrating another exemplary embodiment of a conductive button 155 with a capacitive touch that includes a flexible electrode structure that connects the button to a touch sensing circuit. In contrast to conductive button 100, conductive button 155 includes fewer layers. That is, conductive button 155 does not include conductive rubber, screening layers 120 and fewer insulating rubber layer 125. The remaining elements of conductive button 155 are essentially the same as conductive button 100. Thus, depending on available space or other user device design constraints, conductive button 155 may provide the same functionality as conductive button 100 with fewer elements (e.g., layers).

In both embodiments, a function may be mapped to the detection of capacitance (e.g., when the user touches metal button 105). For example, if conductive button 100 or conductive button 155 is implemented as a power button, when the user touches metal button 105, quick-look information (as described below) may be displayed or a state of the user device may be invoked (e.g., an idle state, etc.). Alternatively, for example, if conductive button 100 or conductive button 155 is implemented as a camera button, when the user touches metal button 105, an auto-focus function may be performed. Additionally, a function may be mapped to the detection of pressure (e.g., when the user presses metal button 105 toward PCB/flexfilm 140 and activates dome switch 135). For example, the function may be to turn on/off user device 150, unlock the user device, take a picture with a camera, etc.

Turning to other embodiments described herein, a common occurrence by users of mobile devices is to check the time. This may occur when the display of the mobile device is off or in a power-saving mode (e.g., a sleep state, an idle mode, etc.). When the user provides some input, the central processing unit (CPU) of the mobile device may be awoken, and in turn, the display may be awoken to display a user interface (e.g., a main screen, a lock screen, etc.). According to an exemplary scenario, the user interface may include the time. The user may glance at the display to obtain the time. After the user checks the time, the display remains on for a period of time. As a result, the mobile device unnecessarily wastes power as a result of the user's desire to check the time. While the incorporation of an organic light-emitting diode (OLED) display into the mobile device may minimize power consumption, the OLED display will still remain on after the user checks the time absent the user pressing a power button to turn off the mobile device, and even then, the shut-down process of the mobile device still consumes power.

According to an exemplary embodiment, a touch sensitive button causes a display to turn on when a user touches the touch sensitive button and turn off the display when the user no longer touches the touch sensitive button. According to an exemplary embodiment, the touch sensitive button includes a capacitive touch button. According to an exemplary implementation, the capacitive touch button is a power button. According to another exemplary implementation, the capacitive touch button is a camera button.

According to an exemplary embodiment, when a user touches the touch sensitive button, a control event is generated that awakens the CPU/software causing a user interface to display quick-look information. For example, quick-look information may include date and time information or date, day, and time information. Additionally, or alternatively, quick-look information may include mobile device status information (e.g., a battery level, strength of network connection, etc.). Additionally, or alternatively, quick-look information may include messaging information. For example, the messaging information may include information pertaining to incoming messages (e.g., e-mails, text messages (e.g., Short Messaging Service (SMS) messages, Multimedia Messaging Service (MMS) messages, telephone calls, social network-related events, etc.). Quick-look information may be represented by text, icons, and/or other graphical elements.

According to an exemplary embodiment, the user interface that includes the quick-look information occupies a smaller area of the display than the total area available on the display. That is, the user interface occupies less than one hundred percent of the display. In this way, the amount of power needed to display the quick-look information may be minimized. According to another exemplary embodiment, the user interface that includes the quick-look information occupies the entire area available on the display. According to an exemplary embodiment, the user interface includes a predefined image. The predefined image may allow for some updates to the image, such as a time update, a number of notifications update, etc., as described herein.

According to an exemplary embodiment, the user interface displayed is displayed as long as the user touches the touch sensitive button and when the user removes his/her finger the display shuts off again. According to an exemplary embodiment, the display is an OLED display. According to other embodiments, the display is another type of display (e.g., an LED display, a liquid crystal display (LCD), a type of touch display, a touchless display, etc.).

According to another embodiment, the touch sensitive button includes a dome switch. According to such an embodiment, when the user compresses the dome switch and releases the dome switch the user interface is displayed that includes quick-look information. The user may compress and release the dome switch again to turn off the display.

According to an exemplary embodiment, a mobile device includes a sensor subsystem that causes a quick-look user interface to be displayed on the display without waking a processing unit (e.g., a central processing unit (CPU)) of the mobile device.

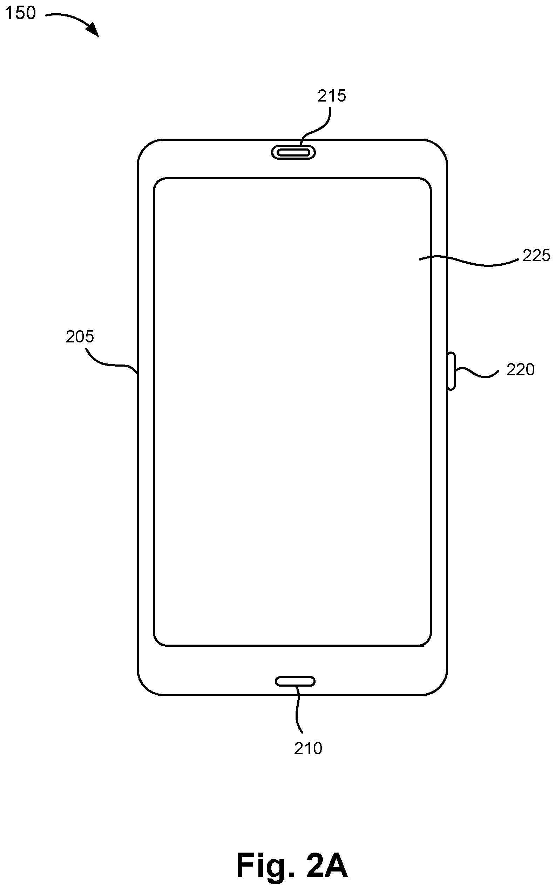

Fig. 2A is a diagram of an exemplary user device 150 in which exemplary embodiments described herein may be implemented. User device 150 may be implemented as a mobile device. For example, the mobile device may take the form of a mobile telephone, a smartphone, a personal digital assistant (PDA), a tablet device, a palmtop device, or a netbook.

As illustrated in Fig. 2A, user device 150 comprises a housing 205, a microphone 210, a speaker 215, a button 220, and a display 225. According to other embodiments, user device 150 may comprise fewer components, additional components, different components, and/or a different arrangement of components than those illustrated in Fig. 2A and described herein. Additionally, user device 150 may take the form of a different configuration (e.g., a slider, a clamshell, etc.) than the configuration illustrated in Fig. 2A.

Housing 205 comprises a structure to contain components of user device 150. For example, housing 205 may be formed from plastic, metal, or some other type of material. According to an exemplary embodiment, housing 205 is made from a conductive material. Housing 205 supports microphone 210, speaker 215, button 220, and display 225.

Microphone 210 is capable of transducing a sound wave to a corresponding electrical signal. For example, a user may speak into microphone 210 during a telephone call or to execute a voice command. Speaker 215 is capable of transducing an electrical signal to a corresponding sound wave. For example, a user may listen to music or listen to a calling party through speaker 215.

Button 220 provides an input to user device 150. Button 220 may be implemented as conductive button 100, conductive button 155, a conventional, or other currently available touch button. Alternatively, button 220 may comprise a push-button functionality.

Display 225 may operate as an output component. For example, display 225 may comprise a liquid crystal display (LCD), a plasma display panel (PDP), a field emission display (FED), a thin film transistor (TFT) display, or some other type of display technology (e.g., OLED, active matrix OLED (AMOLED), etc).

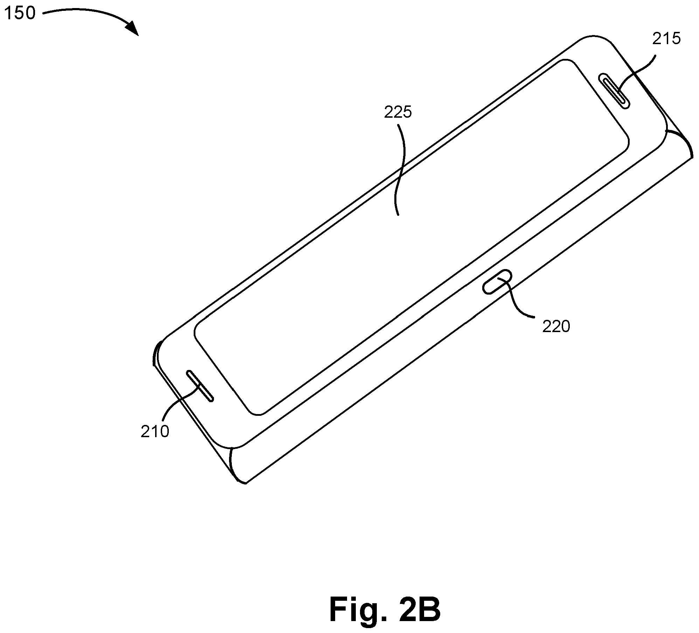

Additionally, display 225 may operate as an input component. For example, display 225 may comprise a touch-sensitive screen. In such instances, display 225 may correspond to a single-point input device (e.g., capable of sensing a single touch) or a multipoint input device (e.g., capable of sensing multiple touches that occur at the same time). Further, display 225 may be implemented using a variety of sensing technologies, including but not limited to, capacitive sensing, surface acoustic wave sensing, resistive sensing, optical sensing, pressure sensing, infrared sensing, or gesture sensing. Additionally, or alternatively, display 225 may comprise a touchless screen. Display 225 is capable of displaying text, pictures, video, various images (e.g., icons, objects, etc.) that may be selected by a user to access various applications, enter data, and/or navigate, etc. Fig. 2B is diagram illustrating another view of user device 150. Button 220 is positioned in a location to allow easy actuation of button 220 when the user holds user device 150 in his/her hand.

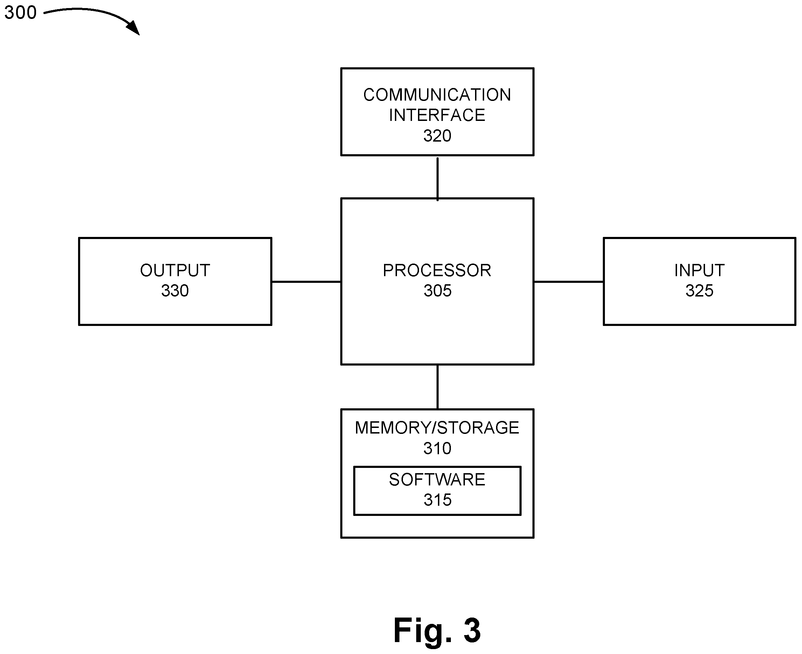

Fig. 3 is a diagram illustrating exemplary components of a device 300 that may correspond to user device 150 depicted in the previous figures and described herein. As illustrated, according to an exemplary embodiment, device 300 includes a processor 305, memory/storage 310, software 315, a communication interface 320, an input 325, and an output 330. According to other embodiments, device 300 may include fewer components, additional components, different components, and/or a different arrangement of components than those illustrated in Fig. 3 and described herein.

Processor 305 includes one or multiple processors, microprocessors, data processors, co-processors, application specific integrated circuits (ASICs), controllers, programmable logic devices, chipsets, field-programmable gate arrays (FPGAs), application specific instruction-set processors (ASIPs), system-on-chips (SoCs), central processing units (e.g., one or multiple cores), microcontrollers, and/or some other type of component that interprets and/or executes instructions and/or data. Processor 305 may be implemented as hardware (e.g., a microprocessor, etc.), a combination of hardware and software (e.g., a SoC, an ASIC, etc.), may include one or multiple memories (e.g., memory/storage 310), etc.

Processor 305 controls the overall operation or a portion of operation(s) performed by device 300. Processor 305 performs one or multiple operations based on an operating system and/or various applications or programs (e.g., software 315). Processor 305 may access instructions from memory/storage 310, from other components of device 300, and/or from a source external to device 300 (e.g., a network, another device, etc.).

Memory/storage 310 includes one or multiple memories and/or one or multiple other types of storage mediums. For example, memory/storage 310 may include one or multiple types of memories, such as, random access memory (RAM), dynamic random access memory (DRAM), cache, read only memory (ROM), a programmable read only memory (PROM), a static random access memory (SRAM), a single in-line memory module (SIMM), a phase-change memory (PCM), a dual in-line memory module (DIMM), a flash memory, and/or some other type of memory. Memory/storage 310 may include a hard disk (e.g., a magnetic disk, an optical disk, a magneto-optic disk, a solid state disk, etc.), a Micro-Electromechanical System (MEMS)-based storage medium, and/or a nanotechnology-based storage medium. Memory/storage 310 may include drives for reading from and writing to the storage medium.

Memory/storage 310 may be external to and/or removable from device 300, such as, for example, a Universal Serial Bus (USB) memory stick, a dongle, a hard disk, mass storage, off-line storage, or some other type of storing medium (e.g., a compact disk (CD), a digital versatile disk (DVD), a Blu-Ray® disk (BD), etc.). Memory/storage 310 may store data, software, and/or instructions related to the operation of device 300.

Software 315 may include an application or a program that provides a function and/or a process. Software 315 may include firmware. By way of example, software 315 may comprise a telephone application, a multi-media application, an e-mail application, a contacts application, a calendar application, an instant messaging application, a web browsing application, a location-based application (e.g., a Global Positioning System (GPS)-based application, etc.), a camera application, etc.

Communication interface 320 permits device 300 to communicate with other devices, networks, systems, etc. Communication interface 320 may include one or multiple wireless interfaces and/or wired interfaces. Communication interface 320 may include one or multiple transmitters, receivers, and/or transceivers. Communication interface 320 operates according to one or multiple protocols, a communication standard, and/or the like.

Input 325 permits an input into device 300. For example, input 325 may include a keyboard, a mouse, a display, a touchscreen, a touchless screen, a button, a switch, an input port, speech recognition logic, and/or some other type of visual, auditory, tactile, etc., input component. Output 330 permits an output from device 300. For example, output 330 may include a speaker, a display, a touchscreen, a touchless screen, a light, an output port, and/or some other type of visual, auditory, tactile, etc., output component.

Device 300 may perform a process and/or a function in response to processor 305 executing software 315 stored by memory/storage 310. By way of example, instructions may be read into memory/storage 310 from another memory/storage 310 or read into memory/storage 310 from another device via communication interface 320. The instructions stored by memory/storage 310 causes processor 305 to perform the process or the function. Alternatively, device 300 may perform a process or a function based on the execution of hardware (processor 305, etc.).

As previously described, according to an exemplary embodiment, user device 150 includes a touch sensitive button that causes a display to turn on when a user touches the touch sensitive button and turn off when the user no longer touches the touch sensitive button. When the display is turned on, quick-look information is displayed. A description of exemplary components providing this functionality is described below.

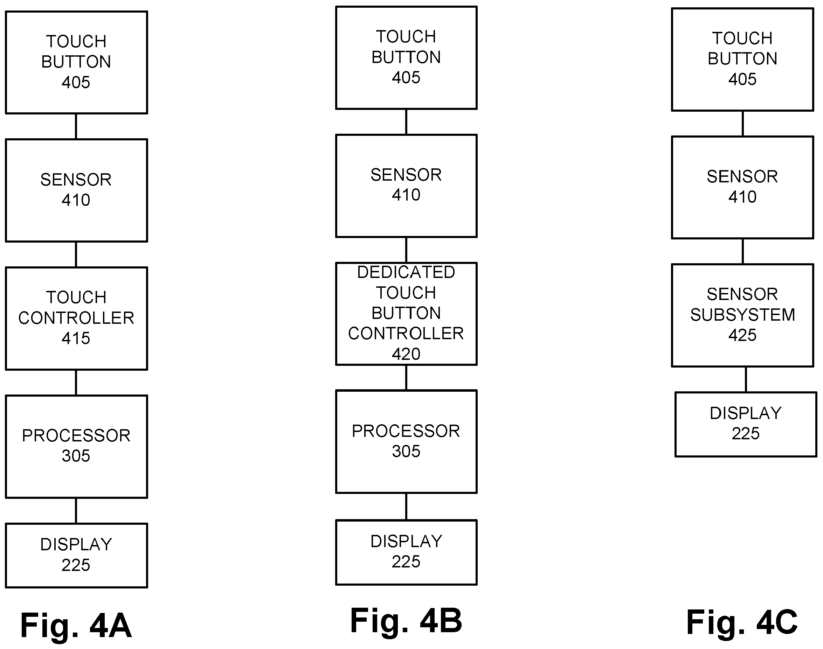

Referring to Fig. 4A, according to an exemplary embodiment, user device 150 includes a touch button 405, a sensor 410, a touch controller 415, and processor 305. According to other implementations, user device 150 may include additional components, fewer components, different components, or some combination thereof.

Touch button 405 includes a touch sensitive button. For example, touch button 405 may be implemented as conductive button 100, conductive button 155, a conventional, or currently available capacitive touch button. According to one implementation, for example, the user may activate touch button 405 by touching, with his or her finger, touch button 405. According to another implementation, the user's finger may not have to come into contact with touch button 405. Rather, the user's finger may be sufficiently proximate to touch button 405 to induce a capacitive flow and activate touch button 405. Although not illustrated, user device 150 may include a component that filters out false activations based on well-known techniques.

Sensor 410 includes a capacitive sensor. Sensor 410 may be implemented as capacitive sensor surface 132 of PCB/flex film 140 and a detection unit capable of detecting a change in the capacitance or a change in the potential across capacitive sensor surface 132.

Touch controller 415 includes logic to control and/or integrate functions associated with display 225. For example, touch controller 415 may control and/or integrate components such as display driving and sensing circuits, power circuits, finger tracking, and signal processing. In one implementation, touch controller 415 may perform the function of the detection unit and sense a change in capacitance or potential across capacitive sensor surface 132. Touch controller 415 is communicatively coupled to processor 305.

According to an exemplary process, when a user activates touch button 405 (e.g., by touching button 105), a capacitive flow reaches and/or is detected by sensor 410. Sensor 410 determines that touch button 405 has been activated based on a sensed level of capacitance or potential. In response, sensor 410 sends a signal to touch controller 415 indicating that touch button 405 has been activated. Touch controller 415 notifies processor 305 of this event (e.g., via an interrupt request). In response, the quick-look information is displayed on display 225. By way of example, processor 305 executes an interrupt handler routine or code. The interrupt handler routine or code includes fetching a pre-defined image. The pre-defined image is then driven and displayed by display 225. For example, the pre-defined image may be loaded into a frame buffer and driven as frame buffer image data.

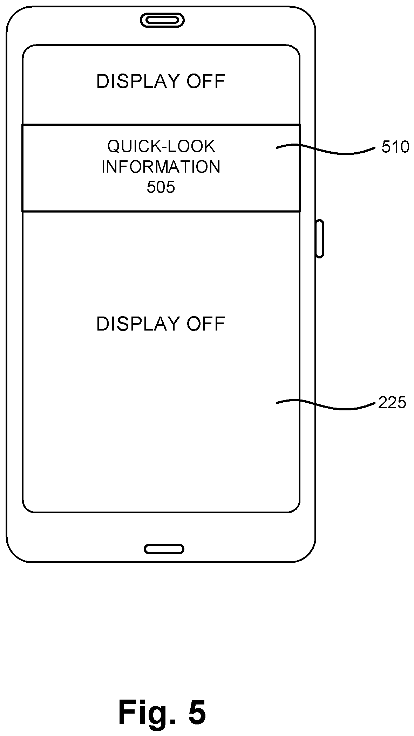

As previously described, the pre-defined image may occupy a smaller area of display 225 than the total area available on display. In this way, the amount of power needed to display the quick-look information may be minimized. For example, referring to Fig. 5, a pre-defined image 510 that includes quick-look information 505, when displayed on display 225, may occupy only a portion of display 225. The other portions of display 225 (labeled display off) in Fig. 5) will not display any information. Various types of pre-defined images 510 may be implemented. For example, pre-defined image 510 may be implemented as a banner or other suitable user interface for displaying quick-look information 505. According to an exemplary implementation, pre-defined image 510 may be a modified screen already known to the user (e.g., a lock screen, a miniature main screen, etc.). Regardless of the implementation, pre-defined image 510 includes quick-look information 505.

In this example, display 225 may be implemented as an OLED, which allows for only a portion of display 225 to be active. According to other examples, this technique may be implemented by another type of display 225 (e.g., an LCD with a zoned backlighting system). The other portions of display 225 remain in an off state or idle state. Additionally, according to this implementation, the color and/or the luminance of pre-defined image 510 may be tailored to reduce the power consumption of the OLED. For example, a white or bright background lends itself to increased power consumption relative to other colors, etc. Red, green, and blue components, for example, of an OLED may have different luminance efficiencies and the color of a pixel impacts power consumption.

Predefined image 510 may allow for some updates to the image data. For example, an update may include a time update. The time update may include an update to the current date (e.g., month, day, and year) and/or time (e.g., hour, minute, seconds). Additionally, or alternatively, for example, the update may include a notification update. For example, the notification update may include an update to the number of received notifications, the type of notifications received (e.g., e-mail, SMS, etc.), and/or sender (e.g., name of person, etc.). Additionally, the update may include a device status update. For example, the device status update may include an update relating to the amount of battery life available, the strength of a network connection, etc.

As previously described, pre-defined image 510 may be displayed on display 225 as long as the user activates touch button 405. In this regard, the time period during which touch button 405 remains activated is known by the interrupt service so as to cause display 225 to continuously display predefined image 510. Additionally, when the user no longer activates touch button 405, the interrupt service no longer causes display 225 to display predefined image 510. For example, an interrupt may be triggered when the user activates touch button 405 and then another interrupt may be triggered when the user no longer activates touch button 405. In between these events, the interrupt service may be silent.

Referring to Fig. 4B, according to another exemplary embodiment, user device 150 includes touch button 405, sensor 410, a dedicated touch button controller 420, and processor 305. According to other implementations, user device 150 may include additional components, fewer components, different components, or some combination thereof.

In contrast to the embodiment illustrated in Fig. 4A, user device 150 includes dedicated touch button controller 420. Dedicated touch button controller 420 performs functions similar to those described above with respect to touch controller 415. For example, according to an exemplary process, when sensor 410 determines that touch button 405 has been activated based on a sensed level of capacitance or potential, sensor 410 sends a signal to dedicated touch button controller 420 indicating that touch button 405 has been activated. Touch button controller 420 notifies processor 305 of this event (e.g., via an interrupt request) and the process continues as described above.

Referring to Fig. 4C, according to yet another exemplary embodiment, user device 150 includes touch button 405, sensor 410, and a sensor subsystem 425. In contrast to the above-mentioned embodiments illustrated in Figs. 4A and 4B, sensor subsystem 425 may not interrupt processor 305. In this way, by not waking-up processor 305, which may be in an idle state, power consumption may be further reduced when displaying quick-look information.

As previously noted, when the user wishes to view quick-look information, user device 150 may be in an idle state, such that display 225 is inactive (e.g., a dark screen). As used herein, "idle state" is intended to be broadly interrupted. For example, the idle state includes that display 225 is inactive (e.g., displays a dark screen). The inactivity or activity of other hardware or hardware and software of user device 150 may vary. By way of further example, in one implementation, the idle state may include background applications running (e.g., a daemon application, etc.). According to another implementation, the idle state may not include any background applications or other applications running. Processor 305 may be in an idle or sleep state. According to yet another implementation, idle state may include communication interface 320 periodically or aperiodically tracking a network connection with wireless nodes (e.g., a base station, etc.). According to still another implementation, the idle state may correspond to a stamina mode. In stamina mode, user device 150 accepts incoming messages (e.g., a telephone call, a text message, etc.), but without notifications (e.g., a beep, information displayed on display 225, etc.). Additionally, in stamina mode, user device 150 blocks all outgoing requests. Other variations of an idle state are possible.

Referring back to Fig. 4C, sensor subsystem 425 may avoid disturbing or waking processor 305. That is, when sensor 410 determines that touch button 405 has been activated based on a sensed level of capacitance or potential, sensor 410 sends a signal to sensor subsystem 425 indicating that touch button 405 has been activated. In contrast to the processes described in relation to Figs. 4A and4B, an interrupt is not sent to processor 305. Rather, sensor subsystem 425 causes pre-defined image 510 to be displayed on display 225. For example, sensor subsystem 425 fetches and loads predefined image 510 into a frame buffer. Sensor subsystem 425 may be communicatively coupled to touch controller 415. In this way, sensor subsystem 425 may be able to act in an isolated way, decoupling processor 305 from touch button detections, and capable of driving a quick-look frame buffer to display 225. Sensor subsystem 425 may have direct communication interfaces towards a touch button controller (e.g., either dedicated or shared with a display touch controller) and display 225, including busses and interrupts.

Although the above description of exemplary components and processes have been explained in relation to touch button 405. As previously described, according to an exemplary embodiment, button 405 may be implemented as a push-button. For example, the push-button may be a power button of user device 150 or a camera button. According to such an exemplary embodiment, the activation of button 405 is caused when the user presses and releases button 405 (e.g., a dome switch or switch). Thereafter, this event causes an interrupt to occur and an interrupt service is provided. Since pre-defined image 510 is not displayed based on the duration of how long the user touches button 405, pre-defined image 510 may be displayed for a predetermined period of time. Alternatively, pre-defined image 510 may be displayed until the user presses and releases button 405 again.

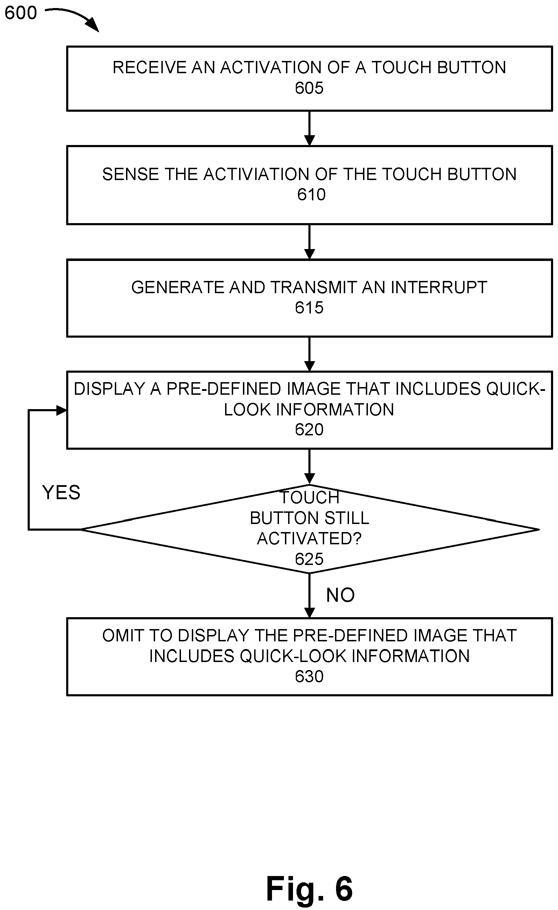

Fig. 6 is a flow diagram illustrating an exemplary process 600 for displaying quick-look information according to an exemplary embodiment. A step or an act described in process 600 may be performed by one or multiple components of user device 150. For example, processor 305 may execute software 315 to perform the step or the act described.

For purposes of description of process 600, it may be assumed that user device 150 is operating in an idle state. Referring to Fig. 6, in block 605, an activation of a touch button is received. For example, a user touches (e.g., with the user's finger) metal button 105 of conductive button 100 or conductive button 155. Alternatively, the user touches a key of another type of capacitive touch button (e.g., a conventional or currently available touch button). Still further, alternatively, for example, the user's finger is placed proximate to the key of the touch button. According to an exemplary implementation, the touch button is a power button of user device 150. According to another exemplary implementation, the touch button is a camera button. According to an exemplary implementation, a metal or conductive housing 205 supports the touch button.

In block 610, an activation of the touch button is sensed. For example, the capacitance associated with the user's finger propagates through conductive rubber, sensing layers 130 of conductive buttons 100 or 155, or other medium of the conventional or currently available touch button. The change in capacitance or potential of capacitive sensor surface 132 or other suitable sensing/sensor pads are detected. Sensor 410 or other detector senses the activation of the touch button.

In block 615, an interrupt is generated and transmitted. For example, sensor 405 transmits a signal to touch controller 415 or dedicated touch button controller 420 indicating that the touch button has been activated. Touch controller 415 or dedicated touch button controller 420 generates and transmits an interrupt to processor 305.

In block 620, a pre-defined image that includes quick-look information is displayed. For example, processor 305 executes an interrupt handler routine or code. The interrupt handler routine or code fetches pre-defined image 510 and causes pre-defined image 510 to be displayed via display 225. According to an exemplary implementation, display 225 is an OLED. According to other implementations, display 225 is implemented using another type of display technology (e.g., LED, etc.).

In block 625, it is determined whether the touch button is still activated. For example, the interrupt service provided by the execution of the interrupt handler routine or code determines whether the touch button is still activated. For example, sensor 410 may continuous transmit a signal or provide some type of notification that the touch button is still activated.

If it is determined that the touch button is still activated (block 625-YES), then process 600 continues to block 620. That is, the pre-defined image continues to be displayed on display 225 as long as the user continues to activate the touch button.

If it is determined that the touch button is not still activated (block 625-NO), then the pre-defined image that includes the quick-look information is no longer displayed (block 630). For example, the interrupt service ends and user device 150 operates in a same state before the touch button was activated. For example, processor 305 may return to doing whatever processor 305 was doing before receiving the interrupt.

Although Fig. 6 illustrates an exemplary process 600 to display quick-look information, process 600 may include additional operations, fewer operations, and/or different operations than those illustrated in Fig. 6 and described herein. For example, with regard to block 615, according to other embodiments of process 600, sensor 410 may notify sensor subsystem 425 in which an interrupt may not be transmitted to processor 305.

According to an exemplary embodiment, user device 150 may offer user preference settings pertaining to what information is included in the pre-defined image. For example, a user may set a preference that configures user device 150 to display date and time as quick-look information. Alternatively, user device 150 may allow the user to select the particular quick-look information (e.g., notification for best friend only, etc.). Additionally, or alternatively, user device 150 may allow the user to set the quick-look information as device status information or incoming message notifications, or any combination of available quick-look information.

According to still another embodiment, user device 150 may allow the user to set one or more touch-tap sequences to display quick-look information. For example, a single tap and a prolonged touch may cause the pre-defined image to include date and time. Alternatively, two single taps and a prolonged touch may cause the pre-defined image to include notifications. In this way, the user is not limited in displaying different types of quick-look information at different times. According to such an embodiment, sensor 410 includes logic to interpret the different touch-tap sequences and generate and transmit corresponding signals so that a particular type of quick-look information is displayed.

The foregoing description of embodiments provides illustration, but is not intended to be exhaustive or to limit the embodiments to the precise form disclosed. Accordingly, modifications to the embodiments described herein may be possible.

The terms "a," "an," and "the" are intended to be interpreted to include one or more items. Further, the phrase "based on" is intended to be interpreted as "based, at least in part, on," unless explicitly stated otherwise. The term "and/or" is intended to be interpreted to include any and all combinations of one or more of the associated items.

In addition, while a series of blocks has been described with regard to the process illustrated in Fig. 6, the order of the blocks may be modified according to other embodiments. Further, non-dependent blocks may be performed in parallel. Additionally, other processes described in this description may be modified and/or non-dependent operations may be performed in parallel.

The embodiments described herein may be implemented in many different forms of software, firmware, and/or hardware. For example, a process or a function may be implemented as "logic" or as a "component." This logic or this component may include hardware (e.g., processor 305, etc.) or a combination of hardware and software (e.g., software 315). The embodiments have been described without reference to the specific software code since software can be designed to implement the embodiments based on the description herein and the accompanying drawings.

Additionally, embodiments described herein may be implemented as a non-transitory storage medium that stores data and/or information, such as instructions, program code, data structures, program modules, an application, etc. For example, a non-transitory storage medium includes one or more of the storage mediums described in relation to memory/storage 310.

The terms "comprise," "comprises" or "comprising," as well as synonyms thereof (e.g., include, etc.), when used in the specification is meant to specify the presence of stated features, integers, steps, or components but does not preclude the presence or addition of one or more other features, integers, steps, components, or groups thereof. In other words, these terms are to be interpreted as inclusion without limitation.

In the preceding specification, various embodiments have been described with reference to the accompanying drawings. It will, however, be evident that various modifications and changes may be made thereto, and additional embodiments may be implemented, without departing from the broader scope of the invention as set forth in the claims that follow. The specification and drawings are accordingly to be regarded as illustrative rather than restrictive.

In the specification and illustrated by the drawings, reference is made to "an exemplary embodiment," "an embodiment," "embodiments," etc., which may include a particular feature, structure or characteristic in connection with an embodiment(s). However, the use of the phrase or term "an embodiment," "embodiments," etc., in various places in the specification does not necessarily refer to all embodiments described, nor does it necessarily refer to the same embodiment, nor are separate or alternative embodiments necessarily mutually exclusive of other embodiment(s). The same applies to the term "implementation," "implementations," etc.

No element, act, or instruction described in the present application should be construed as critical or essential to the embodiments described herein unless explicitly described as such.

Use of ordinal terms such as "first," "second," "third," etc., in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

Use of spatially relative terms, such as "beneath," "below," "lower," "above," "upper," "left," "right," and the like, may be used herein for ease of description to describe one element's or feature's relationship to another element or feature as illustrated in the figures. However, the spatially relative terms are intended to encompass different orientations of the element, in addition to the orientation depicted in a figure and described in this description. For example, if an element in the figure is turned over, an element described as "below" or "beneath" another element or another feature would then be oriented "above" the other element or the other feature.

## Claims

1. A user device (150, 300) comprising:
a display (225);
a capacitive touch button (100, 155, 220, 405) comprising a conductive button (105) separate from the display, and wherein the capacitive touch button includes a push-button functionality;
a conductive housing (115, 205), wherein the conductive housing supports the capacitive touch button;
a memory (310), wherein the memory stores software (315) and user preferences indicating a type of quick-look information to be displayed when the capacitive touch button is activated by first user inputs; and
a processor (305), wherein in response to the first user inputs where a user touches the capacitive touch button or comes sufficiently close to touching the capacitive touch button to activate the capacitive touch button, the processor is configured to execute the software to:
output, via the display (225) and while the user device is in an idle state, a pre-defined image (510) that includes said quick-look information (505) for a period of time
equivalent to a period in which the capacitive touch button remains activated,
wherein in response to second user inputs where a user presses the conductive button by
using the push-button functionality, the capacitive touch button is a power button configured to turn on and turn off the user device.

2. The user device of claim 1, further comprising:
a capacitive sensor (410), wherein the capacitive sensor is configured to:
detect when the user touches or comes sufficiently close to touching the capacitive touch button, and
transmit a signal indicating that the capacitive touch button is activated in response to a detection that the capacitive touch button is activated.

3. The user device of claim 2, wherein the memory further stores the pre-defined image, and the user device further comprising:
a controller (415, 420), wherein the controller is configured to transmit an interrupt to the processor (305), and wherein the processor is configured to execute the software to output, via the display and while the user device is in the idle state, the pre-defined image in response to receiving the interrupt.

4. The user device of claim 3, wherein the controller (415, 420) includes a touch screen controller (415) or a dedicated touch button controller (420).

5. The user device of claim 4, wherein the controller (415, 420) is further configured to transmit another interrupt to the processor (305), in response to the user no longer touching the capacitive touch button or no longer coming sufficiently close to touching the capacitive touch button to deactivate the capacitive touch button, and wherein the processor is further configured to execute the software to no longer output, via the display, the pre-defined image, in response to receiving the other interrupt.

6. The user device of claim 1, wherein the quick-look information includes at least one of date and time, user device status indicators, or incoming message notifications.

7. The user device of claim 1, wherein the capacitive touch button comprises:
a first insulating layer (110) located adjacent to at least a portion of the conductive button to prevent capacitance from traveling to the conductive housing (115, 205) of the user device when the user touches or is sufficiently close to touching the conductive button;
a conductive sensing layer (130);
a second insulating layer (125), wherein the conductive sensing layer is between the first insulating layer (110) and the second insulating layer, and wherein the conductive sensing layer includes a first portion in contact with the conductive button and a second portion in contact with a sensing pad (137); and
a switch (135), wherein the switch is below the second insulating layer and the switch is configured to activate when the conductive button is depressed, and wherein the conductive sensing layer and the second insulating layer are made from a flexible material to allow the switch to be activated when the conductive button is depressed.

8. The user device of claim 7, further comprising:
a first screening layer (127), wherein the first screening layer is located between the second insulating layer (125) and the switch (130); and
a second screening layer (120), wherein the second screening layer is between the first insulating layer (110) and the second insulating layer (125).

9. The user device of claim 1, wherein the capacitive touch button is on a side of the user device.

10. The user device of claim 1, wherein the display includes an organic light-emitting diode, and wherein the pre-defined image occupies only a portion of the display and a remaining portion of the display is inactive.

11. The user device of claim 1, wherein the user device is a mobile device that includes a wireless telephone.

12. A method comprising:
storing, by a device (150, 300), a predefined image that includes quick-look information;
sensing, (610) by the device, first user inputs where a user touches or comes sufficiently close to touching a touch button (100, 155, 220, 405) of the device wherein the touch button is a capacitive touch button comprising a conductive button (105) separate from a display of the device, wherein the capacitive touch button is a power button that is able to turn on and turn off the user device in response to second user inputs where the user presses the capacitive touch button by using a push-button functionality; and
displaying, (620) by a processor (305), that controls the operations on the device, on a display (225), in response to the sensing, the predefined image, while the device remains in an idle state during an entire time of the displaying.

13. The method of claim 12, wherein the predefined image comprises at least one of date and time, a user device status indicator, or an incoming message notification, and the method further comprises:
updating, by the device, the pre-defined image.

14. The method of claim 12, wherein the displaying further comprises:
displaying, by the device, the pre-defined image during an entire time the touch button is user-activated.

15. The method of claim 12, wherein the displaying further comprises:
displaying, by the device, the pre-defined image within only a portion of a display (225) of the device, and wherein a remaining portion of the display does not display any image and remains in an off state.

## Patentansprüche

1. Endgerät (150, 300), aufweisend:
eine Anzeige (225);
ein kapazitiver berührungssensitiver Schaltknopf, aufweisend einen leitfähigen Schaltknopf (105), welcher von der Anzeige getrennt ist, wobei der kapazitive Schaltknopf eine drucksensitive Schaltknopffunktionalität aufweist;
eine leitfähige Einhausung (115, 205), wobei die leitfähige Einhausung den kapazitiven berührungssensitiven Schaltknopf trägt;
einen Speicher (310), wobei der Speicher eine Software (315) und Benutzereinstellungen, welche einen Typ an Schnellblickinformationen angeben, welche anzuzeigen sind, sobald der kapazitive berührungssensitive Schaltknopf durch erste Benutzereingaben aktiviert wird, aufweist; und
ein Prozessor (305), wobei, in Erwiderung auf die ersten Benutzereingaben, bei welchen ein Benutzer den kapazitiven berührungssensitiven Schaltknopf berührt oder ihm hinreichend nahe kommt, um das Berühren des berührungssensitiven Schaltknopfes herbeizuführen, um den kapazitiven berührungssensitiven Schaltknopf zu aktivieren, der Prozessor ausgestaltet ist, um die Software auszuführen zum:
Ausgeben, über die Anzeige (225) und während das Endgerät in einem Ruhemodus ist, eines vorbestimmten Bildes (510), das die Schnellblickinformationen (510) für eine Zeitspanne aufweist, welche einer Zeitspanne entspricht, in welche der kapazitive berührungssensitive Schaltknopf aktiviert bleibt,
wobei in Erwiderung auf zweite Benutzereingaben, bei welchen ein Benutzer den leitfähigen Schaltknopf durch Drücken der drucksensitiven Schaltknopffunktionalität betätigt, der kapazitive berührungssensitive Schaltknopf eine Betriebstaste ist, welche dazu eingerichtet ist das Endgerät einzuschalten und auszuschalten.

2. Endgerät nach Anspruch 1, ferner aufweisend:
ein kapazitiver Sensor (410), wobei der kapazitive Sensor eingerichtet ist zum:
Erkennen, wenn der Benutzer den kapazitiven berührungssensitiven Schaltknopf berührt oder einem Berühren des kapazitiven berührungssensitiven Schaltknopf hinreichend nahekommt, und
Übertragen eines Signals, welches anzeigt, dass der kapazitive berührungssensitive Schaltknopf in Erwiderung auf eine Erkennung, dass der kapazitive berührungssensitive Schaltknopf aktiviert wird, aktiviert wird.

3. Endgerät nach Anspruch 2, wobei der Speicher ferner das vorbestimmte Bild speichert, und das Endgerät ferner aufweist:
eine Steuerung (415, 420), wobei die Steuerung ausgestaltet ist, um eine Unterbrechung zu dem Prozessor (305) zu übertragen, und wobei der Prozessor ausgestaltet ist, um die die Software auszuführen, um über die Anzeige und während sich das Endgerät in dem Ruhemodus befindet das vorbestimmte Bild in Erwiderung auf das Empfangen der Unterbrechung auszugeben.

4. Endgerät nach Anspruch 3, wobei die Steuerung (415, 420) eine Touchscreen-Steuerung (415) oder eine entsprechende berührungssensitive Schaltknopf-Steuerung (420) aufweist.

5. Endgerät nach Anspruch 4, wobei in Erwiderung auf ein längeres Nichtberühren des Benutzers oder ein längeres nicht hinreichendes Nahekommen zum Berühren des kapazitiven berührungssensitiven Schaltknopfes, um den kapazitiven Schaltknopf zu deaktivieren die Steuerung (415, 420) ferner dazu eingerichtet ist, einer weitere Unterbrechung an den Prozessor (305) zu übertragen, und wobei der Prozessor ferner dazu eingerichtet ist, um in Erwiderung auf ein Erfassen der anderen Unterbrechung die Software auszuführen, um über die Anzeige das vorbestimmte Bild nicht länger auszugeben.

6. Endgerät nach Anspruch 1, wobei die Schnellblickinformationen mindestens eines von Datum und Zeit, Endgerät-Statusangaben oder eingehende Benachrichtigungsmeldungen aufweisen.

7. Endgerät nach Anspruch 1, wobei der kapazitive berührungssensitive Schaltknopf aufweist:
eine erste Isolierschicht (110), welche benachbart zu mindestens einem Abschnitt des leitfähigen Schaltknopfes angeordnet ist, um ein Ausbreiten einer Kapazität zu der leitfähigen Einhausung (115, 205) des Endgeräts zu vermeiden, sobald der Benutzer den leitfähigen Schaltknopf berührt oder ihm zum Berühren hinreichend nahe kommt;
eine leitfähige Erkennungsschicht (130);
eine zweite Isolierschicht (125), wobei die leitfähige Erkennungsschicht zwischen der ersten Isolierschicht (110) und der zweiten Isolierschicht angeordnet ist, und wobei die leitfähige Erkennungsschicht einen ersten Abschnitt, welcher mit dem leitfähigen Schaltknopf in Kontakt ist, und einen zweiten Abschnitt, welcher mit einer Erkennungsunterlage (137) in Kontakt ist, aufweist; und
einen Schalter (135), wobei der Schalter unterhalb der zweiten Isolierschicht angeordnet ist und wobei der Schalter zur Aktivierung ausgestaltet ist, sobald der leitfähige Schaltknopf gedrückt wird, und wobei die leitfähige Erkennungsschicht und die zweite Isolierschicht aus einem flexiblen Material erstellt sind, um es dem Schalter zu ermöglichen aktiviert zu werden, sobald der leitfähige Schaltknopf gedrückt wird.

8. Endgerät nach Anspruch 7, ferner aufweisend:
eine erste Screening-Schicht (127), wobei die erste Screening-Schicht zwischen der zweiten Isolierschicht (125) und dem Schalter (130) angeordnet ist; und
eine zweite Screening-Schicht (120), wobei die zweite Schutzschicht zwischen der ersten Isolierschicht (110) und der zweiten Isolierschicht (125) angeordnet ist.

9. Endgerät nach Anspruch 1, wobei der kapazitive berührungssensitive Schaltknopf auf einer Seite des Endgeräts angebracht ist.

10. Endgerät nach Anspruch 1, wobei die Anzeige eine organische Licht emittierende Diode aufweist, und wobei das vorbestimmte Bild lediglich einen Abschnitt der Anzeige belegt und ein verbleibender Abschnitt der Anzeige inaktiv ist.

11. Endgerät nach Anspruch 1, wobei das Endgerät ein mobiles Endgerät ist, das ein drahtloses Telefon aufweist.

12. Verfahren, aufweisend:
Speichern, durch ein Gerät (150, 300), ein vorbestimmtes Bild, das Schnellblickinformationen aufweist;
Erkennen (610), durch das Gerät, erste Benutzereingaben, bei welchen ein Benutzer einen berührungssensitiven Schaltknopf (100, 155, 220, 405) des Geräts berührt oder ihm hinreichend nahe kommt, wobei der berührungssensitive Schaltknopf ein kapazitiver Schaltknopf ist, der einen leitfähigen Schaltknopf (105) aufweist, welcher getrennt von einer Anzeige des Geräts ist, wobei der berührungssensitive Schaltknopf eine Betriebstaste ist, die imstande ist das Endgerät in Erwiderung auf zweite Benutzereingaben, bei welchen der Benutzer den kapazitiven berührungssensitiven Schaltknopf durch Verwenden einer drucksensitiven Schaltknopffunktionalität betätigt, anzuschalten und auszuschalten; und
Anzeigen (620) auf einem Display (225) durch einen Prozessor (305), der den Betrieb des Geräts steuert, in Erwiderung auf das Erkennen des vorbestimmten Bildes, während das Gerät in einem Ruhemodus während einer gesamten Zeit des Anzeigens verbleibt.

13. Verfahren nach Anspruch 12, wobei das vorbestimmte Bild mindestens eines von Datum und Zeit, ein Endgerät-Statusangeber oder eine eingehende Benachrichtigungsmeldung aufweist, und wobei das Verfahren ferner aufweist:
Aktualisieren des vorbestimmten Bildes durch das Gerät.

14. Verfahren nach Anspruch 12, wobei das Anzeigen ferner aufweist:
Anzeigen, durch das Gerät, des vorbestimmten Bildes während einer gesamten Zeit, in der der berührungssensitive Schaltknopf benutzeraktiviert ist.

15. Verfahren nach Anspruch 12, wobei das Anzeigen ferner aufweist:
Anzeigen, durch das Gerät, des vorbestimmten Bildes innerhalb lediglich eines Abschnittes einer Anzeige (225) des Geräts, und wobei ein verbleibender Abschnitt der Anzeige keinerlei Bild anzeigt und in einem ausgeschalteten Modus verbleibt.

## Revendications

1. Dispositif utilisateur (150, 300) comprenant :
un affichage (225) ;
un bouton tactile capacitif (100, 155, 200, 405) comprenant un bouton conducteur (105) distinct de l'affichage, et le bouton tactile capacitif comprenant une fonctionnalité de bouton poussoir ;
un boîtier conducteur (115, 205), le boîtier conducteur supportant le bouton tactile capacitif ;
une mémoire (310), la mémoire stockant des logiciels (315) et des préférences utilisateur indiquant un type d'informations à consultation rapide devant être affichées lorsque le bouton tactile capacitif est activé par des premières entrées utilisateur ; et
un processeur (305), le processeur, en réponse aux premières entrées utilisateur lorsqu'un utilisateur touche le bouton tactile capacitif ou s'approche suffisamment du bouton tactile capacitif pour activer le bouton tactile capacitif, étant configuré pour exécuter le logiciel afin de :
sortir, par le biais de l'affichage (225) et tandis que le dispositif utilisateur est dans un état de repos, une image prédéfinie (510) qui comprend lesdites informations à consultation rapide (505) pour une durée équivalant à une durée durant laquelle le bouton tactile capacitif demeure activé,
où, en réponse à des deuxièmes entrées utilisateur, lorsqu'un utilisateur presse le bouton conducteur en utilisant la fonctionnalité de bouton poussoir, le bouton tactile capacitif est un bouton poussoir configuré pour allumer et éteindre le dispositif utilisateur.

2. Dispositif utilisateur selon la revendication 1, comprenant, en outre :
un capteur capacitif (410), le capteur capacitif (410) étant configuré pour :
détecter le moment où l'utilisateur touche le bouton tactile capacitif ou s'approche suffisamment dudit bouton, et
transmettre un signal indiquant que le bouton tactile capacitif est activé en réponse à une détection que le bouton tactile capacitif est activé.

3. Dispositif utilisateur selon la revendication 2, dans lequel la mémoire stocke, en outre, l'image prédéfinie, et le dispositif utilisateur comprenant, en outre :
un dispositif de commande (415, 420), le dispositif de commande étant configuré pour transmettre une interruption au processeur (305), et le processeur étant configuré pour exécuter le logiciel afin de sortir, par le biais de l'affichage et tandis que le dispositif utilisateur est à l'état de repos, l'image prédéfinie en réponse à la réception de l'interruption.

4. Dispositif utilisateur selon la revendication 3, dans lequel le dispositif de commande (415, 420) comprend un dispositif de commande d'écran tactile (415) ou un dispositif de commande dédié (420) de bouton tactile.

5. Dispositif utilisateur selon la revendication 4, dans lequel le dispositif de commande (415, 420) est, en outre, configuré pour transmettre une autre interruption au processeur (305), en réponse à l'utilisateur ne touchant plus le bouton tactile capacitif ou ne s'approchant plus suffisamment du bouton tactile capacitif pour désactiver le bouton tactile capacitif, et le processeur étant, en outre configuré pour exécuter le logiciel afin de ne plus sortir, par le biais de l'affichage, l'image prédéfinie, en réponse à la réception de l'autre interruption.

6. Dispositif utilisateur selon la revendication 1, dans lequel les informations à consultation rapide comprennent au moins un des éléments parmi date, heure, indicateurs d'état de dispositif utilisateur, notifications de messages entrants.

7. Dispositif utilisateur selon la revendication 1, dans lequel le bouton tactile capacitif comprend :
une première couche isolante (110) située adjacente à au moins une partie du bouton conducteur pour empêcher la capacitance de se déplacer jusqu'au boîtier conducteur (115, 205) du dispositif utilisateur lorsque l'utilisateur touche le bouton conducteur ou s'approche suffisamment dudit bouton ;
une couche de détection conductrice (130) ;
une seconde couche isolante (125), la couche de détection conductrice étant située entre la première couche isolante (110) et la seconde couche isolante, et la couche de détection conductrice comprenant une première partie en contact avec le bouton conducteur et une seconde partie en contact avec un pavé de détection (137) ; et
un commutateur (135), le commutateur étant situé en dessous de la seconde couche isolante et le commutateur étant configuré pour activation lorsque le bouton conducteur est pressé, et la couche de détection conductrice et la seconde couche isolante étant constituées d'un matériau souple afin de permettre au commutateur d'être activé lorsque le bouton conducteur est pressé.

8. Dispositif utilisateur selon la revendication 7, comprenant, en outre :
une première couche de protection (127), la première couche de protection étant située entre la seconde couche isolante (125) et le commutateur (130) ; et
une seconde couche de protection (120), la seconde couche de protection étant située entre la première couche isolante (110) et la seconde couche isolante (125).

9. Dispositif utilisateur selon la revendication 1, dans lequel le bouton tactile capacitif est situé sur un côté du dispositif utilisateur.

10. Dispositif utilisateur selon la revendication 1, dans lequel l'affichage comprend une diode électroluminescente organique, et l'image prédéfinie occupant uniquement une partie de l'affichage et une partie restante de l'affichage étant inactive.

11. Dispositif utilisateur selon la revendication 1, dans lequel le dispositif utilisateur est un dispositif mobile qui comprend un téléphone sans fil.

12. Procédé comprenant les étapes consistant à :
stocker, par un dispositif, (150, 300), une image prédéfinie qui comprend des informations à consultation rapide ;
détecter, (610) par le dispositif, des premières entrées utilisateur lorsqu'un utilisateur touche un bouton tactile (100, 155, 220, 405) ou s'approche suffisamment dudit bouton du dispositif, le bouton tactile étant un bouton tactile capacitif comprenant un bouton conducteur (105) distinct d'un affichage du dispositif, le bouton tactile capacitif étant un bouton d'alimentation qui est apte à allumer et éteindre le dispositif utilisateur en réponse à des deuxièmes entrées utilisateur, lorsque l'utilisateur presse le bouton tactile capacitif en utilisant une fonctionnalité de bouton poussoir ; et
afficher, (620) par un processeur (305), qui commande les opérations sur le dispositif, sur un affichage (225), en réponse à la détection, l'image prédéfinie, tandis que le dispositif demeure dans un état de repos pendant toute la durée de l'affichage.

13. Procédé selon la revendication 12, dans lequel l'image prédéfinie comprend au moins un des éléments parmi date, heure, indicateur d'état de dispositif utilisateur, notification de message entrant, et le procédé comprend, en outre :
la mise à jour, par le dispositif, de l'image prédéfinie.

14. Procédé selon la revendication 12, dans lequel l'affichage comprend, en outre :
l'affichage, par le dispositif, de l'image prédéfinie pendant toute la durée durant laquelle le bouton tactile est activé par l'utilisateur.

15. Procédé selon la revendication 12, dans lequel l'affichage comprend, en outre :
l'affichage, par le dispositif, de l'image prédéfinie dans une seule partie d'un affichage (225) du dispositif, et une partie restante de l'affichage n'affichant aucune image et demeurant inactive.
